Europäisches Patentamt

European Patent Office

Office européen des brevets

(11) Veröffentlichungsnummer: **0 369 273**
**A1**

## EUROPÄISCHE PATENTANMELDUNG

(21) Anmeldenummer: 89120467.9

(22) Anmeldetag: 06.11.89

(51) Int. Cl.5: **G01R 29/08, H01Q 17/00**

(30) Priorität: 11.11.88 DE 3838259

(43) Veröffentlichungstag der Anmeldung:
**23.05.90 Patentblatt 90/21**

(84) Benannte Vertragsstaaten:
**BE DE FR GB**

(71) Anmelder: **ASEA BROWN BOVERI AG**
**Haselstrasse**
**CH-5401 Baden(CH)**

(72) Erfinder: **Hansen, Diethard, Dr.**
**Bahnhofstrasse 39A**
**CH-8965 Berikon(CH)**

(54) **Verfahren für den Qualitätsvergleich von HF-Absorbern.**

(57) Ein Verfahren für den Qualitätsvergleich von HF-Absorbern, verwendet eine mit einem reflexionsarmen Abschluss versehene TEM-Zelle, bei welcher die Absorberwand (5) mit Vergleichsabsorbern (13) ausgestattet ist. Mit einem Pulsgenerator (9) wird eine steilflankige Pulswelle eingestrahlt und mit einem Sensor (10) eine vom Testabsorber (14) reflektierte Streuwelle detektiert. Mit einer ersten Eichmessung wird eine Reflexion der Absorberwand bestimmt. In einem Testbereich wird der Vergleichsabsorber entfernt und dann mit einer zweiten Eichmessung eine Reflexion einer dahinter liegenden Metallwand (8) bestimmt. In einer Vergleichsmessung wird schliesslich eine Reflexion des im Testbereich angeordneten Testabsorbers (14) bestimmt.

FIG.1

FIG.2

EP 0 369 273 A1

## Verfahren für den Qualitätsvergleich von HF-Absorbern

### Technisches Gebiet

Die Erfindung betrifft ein Verfahren für den Qualitätsvergleich von HF-Absorbern, bei welchem ein Testabsorber in einer TEM-Zelle, welche mit einer Absorberwand aus Vergleichsabsorbern versehen ist, mit einer steilflankigen Pulswelle bestrahlt wird und mit einem Sensor eine vom Testabsorber reflektierte Streuwelle detektiert wird.

### Stand der Technik

Im Zusammenhang mit EMI-Control kommt Hochfrequenz-Absorbern eine grosse Bedeutung zu. Diese werden insbesondere dazu eingesetzt, um anechoische Testräume zu schaffen.

Um die Eigenschaften von HF-Absorbern zu bestimmen werden vornehmlich zwei Methoden benützt, nämlich die Arch-Methode und die Waveguide-Methode. Beide haben den prinzipiellen Nachteil, dass sie auf hohe Frequenzen (ab ca. 100 MHz) beschränkt sind. Bei der Arch-Methode wird die Begrenzung duch die Grösse der Antenne und bei der Waveguide-Methode durch die Cutoff-Bedingung des geführten Modes, resp. die Querabmessung des Wellenleiters gegeben.

Aus der Veröffentlichung "An Investigation into the Scattering and Radiation Characteristic of RF-Absorbers", D Hansen, N. Ari, H. Garbe, IEEE 1988 International Symposium on EMC, Seattle, USA, August 2-4, 1988, ist nun eine Vorrichtung bekannt, mit welcher sich der Frequenzgang von HF-Absorbern auch unterhalb von 100 MHz ausmessen lässt. Dabei wird in eine als Testzelle dienende TEM-Zelle ein zu vermessender Testabsorber eingebracht. Allein schon dadurch ergeben sich gegenüber den beiden üblichen Methoden gewaltige Vorteile. Untersuchungen haben aber gezeigt, dass mit der seit neustem bekannten Methode die Möglichkeiten der TEM-Zelle noch nicht ausgeschöpft sind.

### Darstellung der Erfindung

Aufgabe der Erfindung ist es daher, ein Verfahren der eingangs genannten Art zu optimieren.

Erfindungsgemäss besteht die Lösung darin, dass bei einem solchen Verfahren

a) eine erste Eichmessung durchgeführt wird, bei welcher eine Reflexion der Absorberwand bestimmt wird,

b) eine zweite Eichmessung durchgeführt wird, bei welcher in einem Testbereich der Absorberwand die Vergleichsabsorber entfernt sind und eine Reflexion einer dahinter liegenden Metallwand bestimmt wird,

c) eine Vergleichsmessung durchgeführt wird, bei welcher eine Reflexion des im Testbereich angeordneten Testabsorbers bestimmt wird, und

d) dass die TEM-Zelle mit einem reflexionsarmen Leitungsabschluss versehen ist.

Gemäss einer bevorzugten Ausführungsform der Erfindung liegt der Testbereich in der Umgebung einer Mitte einer Längsseite der rechteckigen Absorberwand. Der Sensor ist dabei in einem Abstand D von der Frontfläche angeordnet, wobei der Abstand D etwa einem Drittel einer Gesamtlänge der TEM-Zelle entspricht.

Ebenso ist es Aufgabe der Erfindung eine entsprechende Vorrichtung zum Durchführen von Qualitätsvergleichen zu schaffen.

Die erfindungsgemässe Vorrichtung zeichnet sich aus

a) durch eine TEM-Zelle, bei welcher eine TEM-Welle durch einen Innenleiter und einen Aussenleiter geführt wird und an einem Ende der TEM-Zelle von einer Absorberwand zur Absorption einer feldgebundenen Energie und einem ohmschen Leitungsabschluss zur Absorption einer leitergebundenen Energie der TEM-Welle absorbiert wird;

b) durch die Reflexionsarmut des Leitungsabschlusses , was derart erreicht wird, dass der Leitungsabschluss in einer durch den Innenleiter bestimmten und in Wellenrichtung liegenden Fläche liegt, der Leitungsabschluss als ein ohmscher Widerstand ausgebildet ist, welcher eine graduelle, serielle Bedämpfung des Innenleiters bewirkt und einen durch den HF-Absorber auf dem Leitungsabschluss zusätzlich hervorgerufenen Kapazitätsbelag lokal kompensiert;

c) durch einen Pulsgenerator zur Erzeugung von steilflankigen Pulswellen;

d) durch einen Sensor, welcher in einem Abstand D von etwa einem Drittel einer Gesamtlänge der TEM-Zelle vor der Absorberwand angeordnet ist; und

e) durch einen Testabsorber, welcher in einem Testbereich der Absorberwand anstelle der Vergleichsabsorber angeornet ist.

Der Erfindung hat folgende wesentliche Vorteile:

1. Es wird eine qualitativ gute TEM-Welle auf das Testobjekt eingestrahlt, da die TEM-Welle vor ihrem Auftreffen auf die Absorberwand bei der Ausbreitung nicht gestört wird.

2. Es treten keine Beugungserscheinungen am Testobjekt auf.

3. Es existiert keine komplizierte Ortsabhängigkeit der Messung wie bei der Waveguide-Methode.

4. Die Eigenschaften der HF-Absorber können detailiert untersucht werden, da unmittelbar die reflektierte Feldwelle, und nicht wie bei einer VSWR-Messung eine mittelbare Grösse gemessen wird.

Weitere vorteilhafte Ausführungsformen der Erfindung ergeben sich aus den abhängigen Patentansprüchen.

## Kurze Beschreibung der Zeichnung

Nachfolgend soll die Erfindung anhand von Ausführungsbeispielen und im Zusammenhang mit der Zeichnung näher erläutert werden. Es zeigen:

Fig. 1 eine Vorrichtung zum Durchführen eines Qualitätsvergleichs von HF-Absorbern;

Fig. 2 eine Frontansicht der Absorberwand; und

Fig. 3 einen reflexionsarmen Leitungsabschluss.

## Wege zur Ausführung der Erfindung

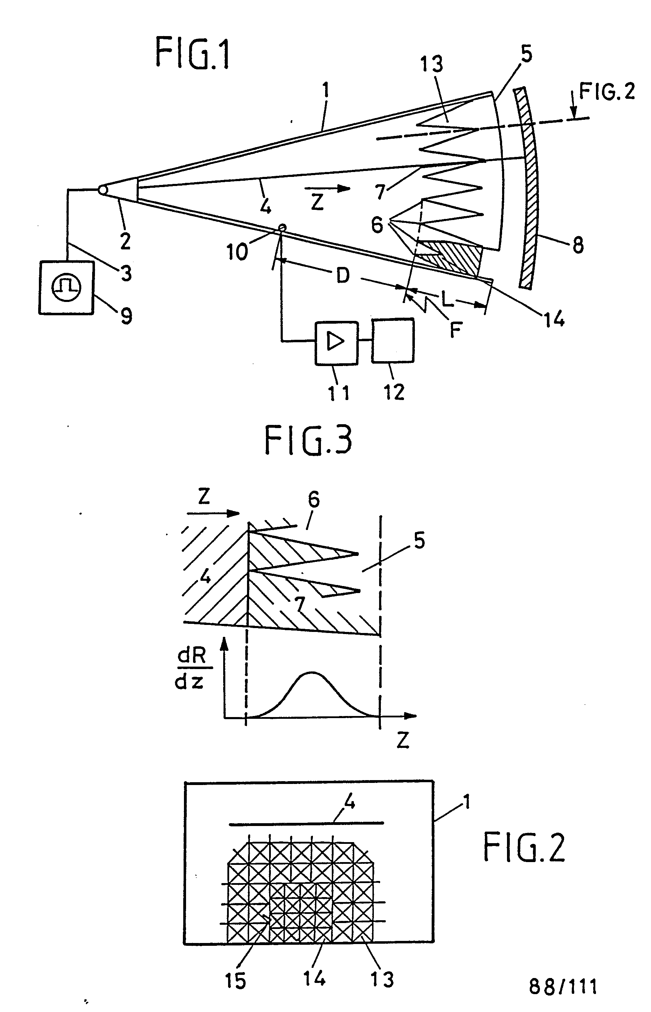

Fig. 1 zeigt die wesentlichen Teile einer erfindungsgemässen Vorrichtung. Sie umfasst eine TEM-Zelle mit einem Aussenleiter 1, einem asymmetrischen Innenleiter 4, einen Speisekeil 2 und eine Absorberwand 5. Ein Koaxialkabel 3 führt eine von einem Pulsgenerator 9 erzeugte, impulsförmige Hochfrequenz (HF) dem Speisekeil 2 zu, der eine TEM-Welle (TEM = transversal elektromagnetisch) erzeugt und in die TEM-Zelle einkoppelt.

Die TEM-Zelle weitet sich von einer Spitze her pyramidenförmig auf. Die Absorberwand 5 befindet sich am aufgeweiteten Ende der TEM-Zelle und ist kugelkalottenförmig. Sie ist z.B. mit Absorberspitzenn 6 versehen und ist an das gewünschte, sich im TEM-Zelle ausbreitende Wellenfeld angepasst. D.h. sie absorbiert den feldgebundenen Teil der Energie der TEM-Welle. Durch die Absorberspitzen 6 wird eine glatte Frontfläche F definiert. Hinter der Absorberwand 5 befindet sich eine Metallwand 8.

In der TEM-Zelle, vorzugsweise am Aussenleiter 1, in einem Abstand D vor der Frontfläche F, wobei der Abstand D etwa einem Drittel einer Gesamtlänge der TEM-Zelle entspricht, ist ein Sensor 10 angeordnet. Ein Verstärker 11 und ein Detektor 12 (Oszillograph, Digitizer) werten eine vom Sensor 10 detektierte Streuwelle aus.

Die Absorberwand 5 besteht aus Vergleichsabsorbern 13 einer gegebenen Länge L. In einem Testbereich der Absorberwand 5 sind die Vergleichsabsorber 13 durch Testabsorber 14 ersetzt. Diese sind nicht grösser als die Vergleichsabsorber 13. Der Testbereich liegt im unteren Teil (d.h im grösseren Teil der durch den Innenleiter 4 asymmetrisch unterteilten TEM-Zelle) in der Mitte.

Fig. 2 zeigt eine Frontalansicht der Absorberwand, d.h. wie sie vom Speisekeil aus gesehen wird. Der Aussenleiter 1 und entsprechend auch die Absorberwand 5 haben bekanntlich einen im wesentlichen rechteckigen Querschnitt, welchem sinngemäss Längsseiten und Breitseiten zugeordnet werden. Der Innenleiter 4 unterteilt diesen Querschnitt parallel zu dessen Längsseite in einen kleinen oberen und einen grossen unteren Bereich. In einem Testbereich 15 sind die Vergleichsabsorber 13 durch Testabsorber 14 ersetzt. Dabei bilden die Absorberspitzen 6 insgesamt eine gemeinsame Frontfläche F. Der Testbereich 15 liegt an einer Längsseite der rechteckigen Absorberwand 5 und zwar etwa in der Mitte dieser Längsseite.

Der Abstand D zwischen Sensor 10 und Frontfläche F bemisst sich grundsätzlich nach dem Raumwinkel, den der Testabsorber 14 in bezug auf den Sensor 10 einnimmt. Vorteilhaft beträgt der Abstand D 0.5 bis 1 m. Der Testbereich entspricht beispielsweise etwa einem Zehntel der Fläche des rechteckigen Querschnitts.

Die TEM-Zelle ist als solche ausführlich in der schweizer Patentanmeldung CH-2026/86-9 beschrieben, deren Inhalt hiermit in der vorliegenden Anmeldung eingeschlossen wird.

Der Innenleiter 1 ist plattenförmig und ist am breiten Ende der TEM-Zelles 1 mit einem Leitungsabschluss 7 versehen. Dieser Leitungsabschluss 7 ist so ausgeführt, dass der leitergebundene Teil der Energie der TEM-WElle absorbiert wird. Durch einen solchen Leitungsabschluss können keine Störungen entstehen und gleichzeitig werden Störmoden, die aus anderen Gründen entstanden sind, bedämpft. Im folgenden werden die wesentlichen Punkte diskutiert, die zu beachten sind, um die Reflexionsarmut zu erhalten.

Erstens muss der Leitungsabschluss 7 in geometrischer Hinsicht so angeordnet sein, dass er in einer durch den Innenleiter 4 bestimmten Fläche liegt. Er stellt also eine ebene Weiterführung des Innenleiters 4 in Richtung des Wellenfeldes dar. (In Fig. 1 zeigt ein mit z bezeichneter Pfeil die Richtung des Wellenfeldes an.) Ein im Innenleiter 4 fliessender Strom wird also knickfrei abgeführt. Dadurch, dass die Stromausbreitung in Wellenrichtung nicht gestört wird, entstehen keine unerwünschten Moden.

Zeitens muss der Leitungsabschluss 7 als ein ohmscher Widerstand ausgebildet sein, welcher eine graduelle serielle Bedämpfung des Innenleiters 4 bewirkt. Dies soll anhand der Figur 3 erläutert werden.

Fig. 3 zeigt wie der reflexionsarme Leitungsabschluss 7 den Innenleiter 4 abschliesst. Es sind die Absorberwand 5 mit den Absorberspitzen 6 angedeutet. Der Leitungsabschluss 7 ist im ganzen Bereich der Absorberwand 6 ausgebildet. Er ist flächenhaft und besitzt in Ausbreitungsrichtung des Wellenfeldes ein Widerstandsprofil dR/dz, welches den durch den Absorberwand 5 auf dem Leitungsabschluss 7 zusätzlich hervorgerufenen Kapazitätsbelag lokal kompensiert. An jeder Stelle "sieht" die TEM-Welle also den lokal angepassten Wellenwiderstand.

Im allgemeinen Fall steigt das Widerstandsprofil dR/dz von einem kleinen Wert beim Uebergang Innenleiter/Leitungsabschluss an auf ein Maximum und fällt dann gegen Ende des Endbereichs wieder auf einen kleinen Wert ab.

Vorteilhaft ist es, wenn der Leitungsabschluss gleichzeitig ein an die Stromverteilung quer zur Ausbreitungsrichtung der TEM-Welle angepasstes Widerstandsprofil aufweist.

Der Leitungsabschluss 7 ist schliesslich so ausgebildet, dass ein durch die Absorberwand 5 und die Absorberspitzen 6 auf dem Innenleiter 4 zusätzlich hervorgerufener Kapazitätsbelag lokal kompensiert wird.

Dieser Leitungsabschluss 7 lässt sich vorzugsweise so realisieren, dass eine Trägerplatte, z.B. eine Sperrholzplatte, mit einer Widerstandsschicht, z.B. Graphitbelag mit geeigneter ortsabhängiger Dicke, versehen wird.

Das erfindungsgemässe Verfahren läuft wie folgt ab.

1. Es wird eine erste Eichmessung durchgeführt. Dabei ist die ganze Absorberwand, also auch im Testbereich, mit Vergleichsabsorbern ausgestattet. Es wird eine steilflankige Pulswelle eingestrahlt und die durch Unvollkommenheiten erzeugte Streuwelle detektiert. (Aufgrund des reflexionsarmen Abschlusses wird das resultierende Signal nahe bei der Detektionsschwelle der Messgeräte liegen.)

2. Es wird eine zweite Eichmessung durchgeführt. Dabei sind im Testbereich die Vergleichsabsorber entfernt, sodass die dahinter liegende Metallwand zum Vorschein kommt. Es wird eine steilflankige Pulswelle eingestrahlt und die von der Metallwand erzeugte Streuwelle detektiert.

3. Es wird eine Vergleichsmessung durchgeführt. Dabei sind im Testbereich die Testabsorber angeornet. wiederum wird eine steilflankige Pulswelle eingestrahlt und die von den Testabsorbern herrührende Streuwelle detektiert.

Die Metallwand stellt den schlechtmöglichsten Testabsorber dar, da sie die Pulswelle überhaupt nicht absorbiert. Andrerseits bietet die nur aus Vergleichsabsorbern bestehende Absorberwand (Testbereich auch mit Vergleichs absorbern ausgestattet) die bestmögliche Absorption. Aus dem Vergleich der drei gemessenen Feldstreuwerte wird die Qualität der Testabsorber ermittelt. Das Verhältnis der Rückstreuung bzw. Absorption der eben auftreffenden TEM-Welle lässt sich daraus nämlich sowohl experimentell als auch analytisch bestimmen.

Mit Hilfe der schnellen Fouriertransformation, kurz FFT genannt, kann z.B. aus der gemessene Streuwelle der Frequenzgang des Testabsorbers berechnet werden. Es sei an dieser Stelle nochmals darauf hingewiesen, dass dies bei der Erfindung für das E-Feld und für das H-Feld getrennt ausgeführt werden kann. Entsprechend kann der Testabsorber viel detaillierter als beim Stand der Technik untersucht werden.

Je steiler die Flanke der Pulswelle, desto grässer die Ortsauflösung der Messung. Eine Pulswelle von z.B. 5 ns Pulsdauer und wenigen 100 ps Anstiegszeit liefert gute Messresultate. Selbstverständlich beschränkt sich die Erfindung nicht auf dieses Zahlenbeispiel.

Als Vergleichsabsorber ist grundsätzlich immer der bessere von zwei zu vergleichenden Absorbertypen einzusetzen. In der Praxis bedeutet das, dass der Testabsorber nicht grösser als der Vergleichsabsorber ist.

Abschliessend kann gesagt werden, dass mit der Erfindung ein Verfahren für den Qualitätsvergleich von HF-Absorbern geschaffen wird, welches nicht nur Messungen höchster Qualität in einem breiten Frequenzbereich ermöglicht, sondern auch die effektiv relevanten Werte erfasst, die zur Bewertung von HF-Absorbern nötig sind.

## Ansprüche

1. Verfahren für den Qualitätsvergleich von HF-Absorbern, bei welchem ein Testabsorber (14) in einer TEM-Zelle, welche mit einer Absorberwand (5) aus Vergleichsabsorbern (13) versehen ist, mit einer steilflankigen Pulswelle bestrahlt wird und mit einem Sensor (10) eine vom Testabsorber reflektierte Streuwelle detektiert wird, dadurch gekennzeichnet, dass

a) eine erste Eichmessung durchgeführt wird, bei welcher eine Reflexion der Absorberwand (5) bestimmt wird.

b) eine zweite Eichmessung durchgeführt wird, bei welcher in einem Testbereich (15) der Absorberwand (5) die Vergleichsabsorber (13) entfernt sind und eine Reflexion einer dahinter liegenden Metallwand (8) bestimmt wird,

c) eine Vergleichsmessung durchgeführt wird, bei welcher eine Reflexion des im Testbereich (15) angeordneten Testabsorbers (14) bestimmt wird, und

d) dass die TEM-Zelle mit einem reflexionsarmen Leitungsabschluss (7) versehen ist.

2. Verfahren nach Anspruch 1, dadurch gekennzeichnet, dass der Testabsorber (14) nicht grösser als der Vergleichsabsorber (13) ist.

3. Verfahren nach Anspruch 1, dadurch gekennzeichnet, dass der Testabsorber (14) bezüglich der Vergleichsabsorber (13) so ausgerichtet ist, dass Testabsorber (14) und Vergleichsabsorber (13) eine gemeinsame Frontfläche (F) bilden.

4. Verfahren nach Anspruch 1, dadurch gekennzeichnet, dass

a) der Testbereich (15) in der Umgebung einer Mitte einer Längsseite der rechteckigen Absorberwand (5)

b) und der Sensor (10) in einem Abstand D von der Frontfläche (F) angeordnet ist, wobei der Abstand D etwa einem Drittel einer Gesamtlänge der TEM-Zelle entspricht.

5. Verfahren nach Anspruch 4, dadurch gekennzeichnet, dass der Abstand D etwa 0.5 bis 1 m beträgt.

6. Vorrichtung zum Durchführen eines Qualitätsvergleichs von HF-Absorbern, gekennzeichnet

a) durch eine TEM-Zelle, bei welcher eine TEM-Welle durch einen Innenleiter (4) und einem Aussenleiter (1) geführt wird und an einem Ende der TEM-Zelle von einer Absorberwand (5) zur Absorption einer feldgebundenen Energie und einem ohmschen Leitungsabschluss (7) zur Absorption einer leitergebundenen Energie der TEM-Welle absorbiert wird;

b) durch die Reflexionsarmut des Leitungsabschlusses (7), was derart erreicht wird, dass der Leitungsabschluss (7) in einer durch den Innenleiter (4) bestimmten und in Wellenrichtung liegenden Fläche liegt, der Leitungsabschluss (7) als ein ohmscher Widerstand ausgebildet ist, welcher eine graduelle, serielle Bedämpfung des Innenleiters (4) bewirkt und einen durch den HF-Absorber (5) auf dem Leitungs abschluss (7) zusätzlich hervorgerufenen Kapazitätsbelag lokal kompensiert;

c) durch einen Pulsgenerator (9) zur Erzeugung von steilflankigen Pulswellen;

d) durch einen Sensor (10), welcher in einem Abstand D von etwa einem Drittel einer Gesamtlänge der TEM-Zelle vor der Absorberwand (5) angeordnet ist; und

e) durch einen Testabsorber (14), welcher in einem Testbereich (15) der Absorberwand (5) anstelle der Vergleichsabsorber (13) angeornet ist.

7. Vorrichtung nach Anspruch 6, dadurch gekennzeichnet, dass der Testabsorber (14) nicht grösser als der Vergleichsabsorber (13) ist.

8. Vorrichtung nach Anspruch 6, dadurch gekennzeichnet, dass der Testabsorber (14) bezüglich der Vergleichsabsorber (13) so ausgerichtet ist, dass Testabsorber (14) und Vergleichsabsorber (13) eine gemeinsame Frontfläche (F) bilden.

9. Vorrichtung nach Anspruch 6, dadurch gekennzeichnet, dass der Abstand D etwa 0.5 bis 1 m beträgt.

10. Vorrichtung nach Anspruch 6, dadurch gekennzeichnet, dass der Testbereich (15) in der Umgebung einer Mitte einer Längsseite der rechteckigen Absorberwand (5) liegt.

# FIG.1

FIG.2

13  5

1

4  Z

7

2

10

D

6

8

3

F

9

14

11  12

# FIG.3

Z  6

4

5

7

$\dfrac{dR}{dz}$

Z

4

1

FIG.2

15  14  13

Europäisches
Patentamt

**EUROPÄISCHER RECHERCHENBERICHT**

Nummer der Anmeldung

EP 89 12 0467

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,Y | EP-A-0 246 544 (BBC)<br>* Zusammenfassung; Spalte 5, Zeilen 13-35; Abbildung 1 *<br>--- | 1,6 | G 01 R 29/08<br>H 01 Q 17/00 |
| Y | NACHRICHTENTECHNIK ELEKTRONIK, Band 15, Nr. 11, November 1965, Seiten 441-443; L.E. GRÄSSLER: "Absorber für elektromagnetische Wellen mit stufenförmigem Dämpfungsverlauf, Teil II"<br>* Seite 441, rechte Spalte, Absatz 6 - Seite 442, rechte Spalte, Absatz 1; Abbildung 9 *<br>--- | 1,6 | |
| A | ELECTRONICS AND COMMUNICATIONS IN JAPAN: PART I: COMMUNICATIONS, Band 69, Nr. 12, Dezember 1986, Seiten 65-71; Y. SHIMIZU et al.: "Absorbing Rubber Sheet Mixed with Carbon for X-Band Marine Radar Frequencies"<br>* Seite 69, rechte Spalte, Absatz 3 - Seite 70, linke Spalte, Absatz 1; Abbildung 11 *<br>----- | 2-4,7,8,10 | |

RECHERCHIERTE SACHGEBIETE (Int. Cl.5)

G 01 R
H 01 Q

Der vorliegende Recherchenbericht wurde für alle Patentansprüche erstellt

| Recherchenort | Abschlußdatum der Recherche | Prüfer |
|---|---|---|
| DEN HAAG | 23-02-1990 | SINAPIUS G.H. |